# EUROPÄISCHE PATENTANMELDUNG

(11) **EP 0 982 575 A2**
(43) Veröffentlichungstag der Anmeldung: **01.03.2000**
(21) Anmeldenummer: 99116066.4
(22) Anmeldetag: 16.08.1999
(51) Int. Cl.: G01L 9/00, G01P 15/08, H04R 7/04

(54) **Mikromechanische Struktur**

(30) Priorität: 27.08.1998 DE 19839123
(71) Anmelder: SIEMENS AKTIENGESELLSCHAFT, 80333 München (DE)
(72) Erfinder: Kolb, Stefan, 85716 Unterschleissheim (DE); Maier-Schneider, Dieter, Dr., 85570 Markt Schwaben (DE); Oppermann, Klaus-Günter, 83607 Holzkirchen (DE); Timme, Hans-Jörg, Dr., 85521 Ottobrunn (DE)

(57) **Zusammenfassung**

Beschrieben ist eine mikromechanische Struktur umfassend ein Substrat, eine Membran, einen Hohlraum, eine Opferschicht und eine Abschlußstruktur, wobei die Abschlußstruktur im Bereich der Membran so ausgenommen ist, daß sich oberhalb der Membran eine Medienöffnung befindet, welche dadurch gekennzeichnet ist, daß der Durchmesser des Hohlraums über den gesamte Umfang des Hohlraums kleiner ist, als der Durchmesser der Öffnung.

Ferner ist ein Verfahren zur Herstellung der vorstehend bechriebenen mikromechanischen Struktur beschrieben.

Die Erfindung betrifft auch die Verwendung der vorstehend beschriebenen mikromechanischen Struktur für Sensoren.

## Beschreibung

Die vorliegende Erfindung betrifft eine mikromechanische Struktur, vorzugsweise ein Sensorelement umfassend ein Substrat, eine Membran, einen zwischen Membran und Substrat angordneten Hohlraum , eine als umlaufende Auflage für die Membran dienende Opferschicht, eine Abschlußstruktur, wobei die Abschlußstruktur (2) im Bereich der Membran so ausgenommen ist, daß sich oberhalb der Membran eine Medienöffnung befindet.
Ferner betrifft die Erfindung ein Verfahren zur Herstellung einer mikromechanischen Struktur
Die Erfindung betrifft auch die Verwendung dieser mikromechanischen Struktur für Sensoren, wie beispielsweise Drucksensoren, Mikrofone oder Beschleunigungssensoren.

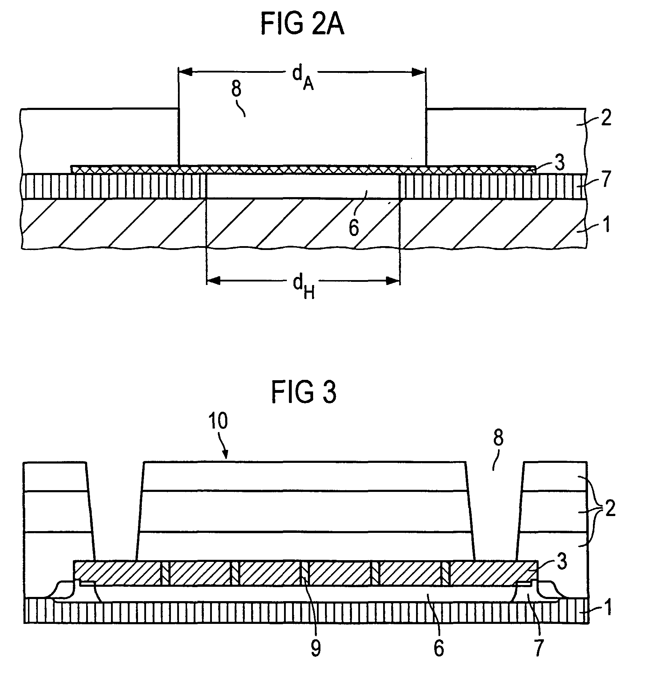

Mikromechanische Strukturen mit auf dem Chip integrierter Ansteuer- bzw. Auswerteelektronik sind beispielsweise aus der EP-A-0 714 017 bekannt. Diese werden beispielsweise als Drucksensoren in der Kfz-Industrie, Beschleunigungssensoren oder in Mikrofonen eingesetzt. Einen im Stand der Technik bekannten Drucksensor zeigt Figur 3. Auf einem Siliziumsubstrat 1 wird mittels konventioneller Halbleiterfertigungstechnologie eine Sensoranordnung umfassend einen Hohlraum 6 und eine Membran 3 aufgebracht. Oberhalb der Membran befindet sich eine Medienöffnung 8. Durch die Medienöffnung kann beispielsweise eine Schallwelle an das Membranmaterial herantreten. Als Folge daraus ergibt sich eine zeitlich abhängige Volumenänderung des Hohlraums 6. Diese Volumenänderung kann in ein elektrisches Signal umgewandelt werden. Dies erfolgt entweder kapazitiv oder über eine Piezoanordnung. Das bekannte Drucksensorelement weist nach Schaffung der Medienöffnungen eine auf der Membranfläche befindliche Reststruktur 10 auf, die von zuvor auf den Chip aufgebrachten Planarisierungs- und Abschlußschichten oder auch zur Bildung von Schaltungsstrukturen benötigten Schichten herrührt. Diese Reststruktur überdeckt durch Verschlußdeckel 9 verschlossene Löcher in der Membran, welche zur Freilegung des Hohlraums 6 benötigt werden.

Für bestimmte Anwendungen werden mikromechanische Strukturen benötigt, die möglichst reproduzierbare Eigenschaften aufweisen. So darf sich beispielsweise an einem Sensor während einer absoluten Druckmessung die Sensorkennlinie über einen längeren Zeitraum im wesentlichen nicht ändern. Insbesondere in Kraftfahrzeugen sind entsprechende Sensoren jedoch aggressiven Umweltbedingungen, wie starke Temperaturunterschiede, hohe Luftfeuchtigkeit, salzhaltige Athmosphäre usw. ausgesetzt. Die vorstehend beschriebene bekannte mikromechanische Struktur erfüllt diese Forderung nur bedingt. In der mikromechanischen Struktur werden die mechanischen Eigenschaften der Membran zu einem beträchtlichen Teil von den auf der Membran befindlichen Reststrukturen bestimmt. Ein weiteres Problem ist, daß die Abschlußstrukturen, die sich im Außenbereich der Membran befinden, auf die mechanischen Eigenschaften der Membran auswirken. Die Abschlußstruktur ist in der Regel wesentlich dicker als die Membran. Hierdurch ergeben sich durch unterschiedliche thermische Ausdehnungskoeffizienten oder fertigungsbedingten Schwankungen Spannungen, die sich auf die Membranfläche auswirken.

Aufgabe der vorliegenden Erfindung ist es, eine Membranstruktur zur Verfügung zu stellen, die in einen Halbleiterherstellungsprozeß integriert werden kann und die oben aufgeführten Nachteile bekannter mikromechanischer Strukturen nicht aufweist.

Diese Aufgabe wird erfindungsgemäß gelöst durch eine mikromechanische Struktur, vorzugsweise durch einen mikromechanischen Sensor, umfassend ein Substrat 1, mindestens eine oberhalb des Substrats angeordnete Membran 3, einen zwischen Membran und Substrat angordneten Hohlraum 6, mindestens eine als umlaufende Auflage für die Membran dienende Opferschicht (7), eine aufseitige Abschlußstruktur 2 welche die Waferoberfläche sowie einen Teilbereich der Membran überdeckt und vorzugsweise auf der Oberseite eben ist, wobei die Abschlußstruktur 2 im Bereich der Membran so ausgenommen ist, daß sich oberhalb der Membran eine Medienöffnung 8 befindet und die Öffnung zumindest teilweise bis zur Membran oder einer ggf. auf der Membran angeordneten Verschlußschicht 4 hinabreicht, welche dadurch gekennzeichnet ist, daß der Durchmesser d_{H} des Hohlraums 6, über den gesamte Umfang des Hohlraums, kleiner ist, als der Durchmesser d_{A} der Öffnung 8.

Die Membran auf der Oberseite weist vorzugsweise keine ebenflächig mit der Abschlußstruktur 2 abschließende Reststrukturen 10 auf. Die Reststrukturen bestehen insbesondere aus Resten der Abschlußstruktur.

Der Verschlußdeckel ist vorzugsweise aufseitig mit einem Ätzstopp 5 bedeckt, wobei ggf. zwischen Atzstopp und Verschlußdeckel eine parallel zur Membranfläche verlaufende durchgehende oder unterbrochene Verschlußschicht 4 vorhanden ist und die Summe der Dicke der Ätzstoppschicht und der ggf. vorhandenen Verschlußschicht geringer ist, als die Dicke der Abschlußstruktur 2. Besonders bevorzugt ist es, wenn die Summe der Ätzstoppschicht und der ggf. vorhandenen Verschlußschicht geringer ist als 50% der Dicke der Abschlußstruktur 2.

Die Fläche des Ätzstopps 5 beträgt bevorzugt weniger als 50% der freigelegten Membranfläche 11. Dabei ist es besonders bevorzugt, wenn die Fläche des Ätzstopps kleiner als 10%, insbesondere kleiner 2%, ist.

Die Ausbildung der Membran ist vorzugsweise einstoffig. Als Membranmaterial kommt insbesondere polykristallines oder einkristallines Silizium zum Einsatz.

Vorzugsweise befindet sich auf dem Chip der Struktur eine Halbleiterschaltung mit einer Auswerte- und/oder Ansteuerelektronik für die mikromechanische Struktur. Für die Herstellung der mikromechanischen Struktur und der Halbleiterschaltung werden bevorzugt Materialien verwendet, die kompatibel zu einem Halbleiterherstellungsprozeß, wie CMOS, BiCMOS oder Bipolar, sind.

Die Erfindung betrifft auch ein Verfahren zur Herstellung einer mikromechanischen Struktur, vorzugsweise eines mikromechanischen Sensors, umfassend die Schritte
a)Herstellung einer mikromechanischen Struktur umfassend ein Substrat 1, mindestens eine oberhalb des Substrats angeordnete Membran 3, welche ggf. Löcher zur Ätzung einer Öffnung 6 aufweist, einen zwischen Membran und Substrat angeordneten Hohlraum 6, mindestens eine als umlaufende Auflagefläche für die Membran dienende Opferschicht 7,
b)Aufbringen einer Abschlußstruktur 2 auf der Oberseite, so daß die Abschlußstruktur den Membranbereich und den außerhalb der Membran liegenden Bereich gemeinsam überdeckt,
c)Ätzung einer Öffnung 8 auf der Oberseite der mikromechanischen Struktur, wobei die Öffnung einen Durchmesser d_{A} hat, welcher über den gesamten Umfang der Öffnung größer ist, als der Durchmesser d_{H} des Hohlraums 6 und
d)Verwendung eines Ätzverfahrens zur Ätzung der Öffnung 8, welches selektiv gegenüber der Membran und einem ggf. einem auf der Membran aufgebrachten Ätzstop 5 ist.

Die Löcher in der Membran werden insbesondere durch Aufbringen der Membran mit einer strukturierten Maske hergestellt.

Nach Verschließen der Löcher wird vorzugsweise auf die Membran oder auf eine ggf. vorhandene Verschlußschicht ein Ätzstopp 5 aufgebracht, wobei der Ätzstopp nur im Bereich der Verschlußdeckel aufgebracht wird. Das Aufbringen des Ätzstopps im Bereich der Verschlußdeckel erfolgt dabei zweckmäßigerweise unter Verwendung einer auf geignete Weise strukturierten Maske.

Ferner betrifft die Erfindung die Verwendung der erfindungsgemäßen mikromechanischen Struktur für Sensoren, inbesondere Drucksensoren, beispielsweise in der Mobiltechnik oder für Mikrofone, oder Beschleunigungssensoren.

Weitere bevorzugte Ausführungsformen der Erfindung sind in den Unteransprüchen 3, 5, 10 und 11 beschrieben.

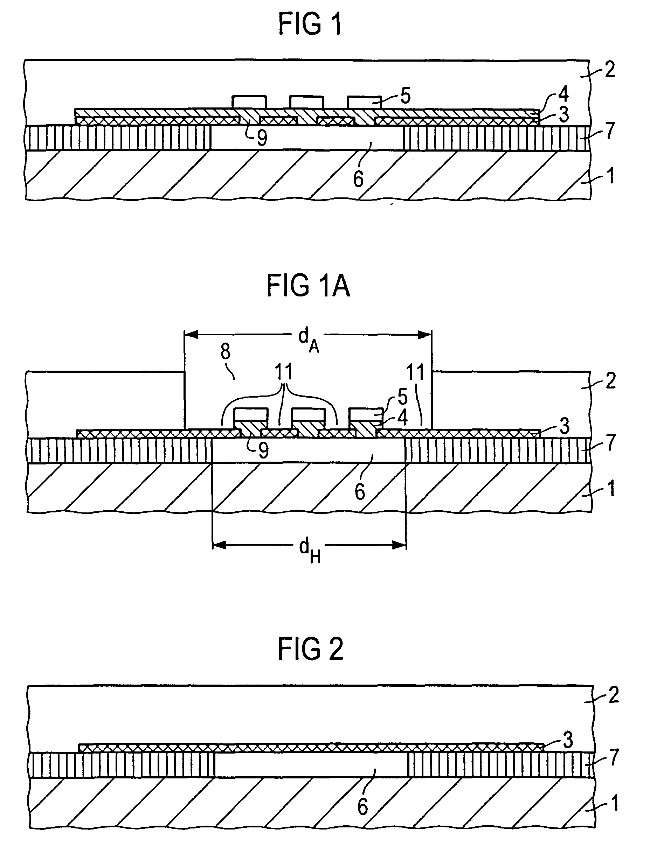

Die Erfindung wird nun anhand der Ausführungsbeispiele in den Figuren 1a und 2a näher erläutert. In den Figuren 1 und 2 sind Ausführungsbeispielse für halbfertige erfindungsgemäße mikromechanische Strukturen dargestellt.

Figur 1 zeigt die mikromechanische Struktur eines erfindungs-Sensors umfassend ein Substrat 1 aus einem Siliziumwafer, einer darauf befindlichen Opferschicht 7 aus Siliziumoxid mit einer Dicke vorzugweise im Bereich von etwa 0,2 bis 4 µm, eine Membranschicht 3 aus Polysilizium oder einkristallinem Silizium, einer Verschlußschicht 4 aus einem geeigneten Material, welches vorzugsweise BPSG, ein Oxid oder ein Nitrid ist, einem Ätzstopp 5 aus einem geeignetem Material, wobei vorzugsweise als Ätzstop Aluminium, undotiertes Silizium oder dotiertes Silizium eingesetzt wird, und einer Abschlußstruktur 2 bestehend aus Schichten, welche in der Halbleiterfertigung üblich sind. Die Abschlußstruktur besteht bevorzugt aus Oxidzwischenschichten und einer Passivierungsschicht aus Plasmanitrid. Figur 1 zeigt einen halbfertigen erfindungsgemäßen Sensor mit durchgehender Abschlußstruktur 2. In Figur 1a ist aus dem mikromechanischen Sensor gemäß Figur 1 eine Medienöffnung 8 herausgeätzt. Die Ätzung der Medienöffnung 8 wird selektiv gegen die Membranfläche und den Ätzstop 5 durchgeführt.

Figur 2 zeigt eine halbfertige Struktur für eine weitere Ausführungsform gemäß Fig. 2a . Der Sensor weist eine durchgehende Membranfläche 3 auf. Die Ätzung des Hohlraums 6 wird von der Seite durchgeführt. Figur 2a zeigt den mikromechanischen Sensor mit ausgeätzter Medienöffnung 8.

Die Medienöffnung 8 in den Figuren 1a und 2a hat einen Durchmesser d_{A}, welcher an jeder Stelle des Umfangs der Medienöffnung größer ist, als der Durchmesser d_{H} der darunterliegenden Öffnung des Hohlraums 6. Hierdurch entsteht im Bereich der Auflagefläche der Membran eine Stufe. Diese Stufe führt zu einer Auflage der Membran im wesentlichen auf der Opferschicht 7. Durch den im gesamten Bereich der Membranauflage kleineren Durchmesser des Hohlraums 6 wirken sich durch die Abschlußstruktur hervorgerufene Spannungen nicht auf die Membranfläche 6 aus. Die Opferschicht 7 stützt die Membran in der Weise ab, daß diese nicht durch mechanische Spannungen verformt wird.

Das Verfahren zur Herstellung des erfindungsgemäßen Sensors wird anhand der Figuren 1 und 1a im folgenden beispielhaft näher erläutert. Zunächst wird auf den Wafer 1 eine Opferschicht und eine Membranschicht aufgebracht. Im Anschluß daran wird entsprechend dem in der EP-A 0 783 108 beschriebenen Verfahren ein Hohlraum 6 hergestellt. Hierzu wird die Membranschicht mit einer Fototechnik strukturiert, so daß sie Öffnungen aufweist. Mit einem isotropen Ätzprozeß wird die Hilfsschicht bis zum Substrat geätzt, so daß ein Hohlraum 6 unterhalb der Membranöffnungen entsteht. Die Herstellung des Hohlraums kann jedoch auch nach anderen üblichen Methoden durchgeführt werden. Im Anschluß daran wird eine BPSG-Schicht aufgebracht. Ihre Dicke ist so gewählt, daß über den Öffnungen in der Membran nach dem Abscheiden höchstens ein schmaler Spalt verbleibt, welcher durch einen darauf folgenden Schließprozeß geschlossen werden kann. Hierdurch entstehen im Bereich der Membranöffnungen Verschlußdeckel 9. Diese Verschlußdeckel bestehen beispielsweise aus einem Oxidmaterial wie etwa Siliziumoxid. Schließlich wird im Bereich der Membranöffnungen eine durch Maskierung strukturierte Schicht aufgebracht, die bei der Ätzung der Medienöffnung 8 als Ätzstopp wirkt. Nach Freilegung der Medienöffnung 8 bleiben auf der Membran nur kleiner Reste der Ätzstoppschicht und der Verschlußschicht 4 stehen. Die Fläche der Ätzstoppschicht beträgt besonders bevorzugt weniger als 2% bezüglich der Fläche der Membran.

Die erfindungsgemäße mikromechanische Struktur kann mit reproduzierbaren Eigenschaften hergestellt werden. Der Einfluß der während des Halbleiterherstellungsprozesses entstehenden Abschlußstruktur auf die Membran ist vernachlässigbar klein. Ein weiterer Vorteil ist es, daß auf der Membran keine Reststruktur verbleibt, die ebenflächig mit der Abschlußstruktur abschließt.

## Patentansprüche

1. Mikromechanische Struktur umfassend ein Substrat (1), mindestens eine oberhalb des Substrats angeordnete Membran (3), einen zwischen Membran und Substrat angordneten Hohlraum (6), mindestens eine als umlaufende Auflage für die Membran dienende Opferschicht (7), eine aufseitige Abschlußstruktur (2) welche die Waferoberfläche sowie einen Teilbereich der Membran überdeckt, wobei die Abschlußstruktur (2) im Bereich der Membran so ausgenommen ist, daß sich oberhalb der Membran eine Medienöffnung (8) befindet und die Öffnung zumindest teilweise bis zur Membran oder einer ggf. auf der Membran angeordneten Verschlußschicht (4) hinabreicht,
**dadurch gekennzeichnet**,
daß der Durchmesser (d_{H}) des Hohlraums (6), über den gesamte Umfang des Hohlraums, kleiner ist, als der Durchmesser (d_{A}) der Öffnung (8).

2. Mikromechanische Struktur nach Anspruch 1,
**dadurch gekennzeichnet**,
daß die Membran auf der Oberseite keine ebenflächig mit der Abschlußstruktur (2) abschließende Reststrukturen (10) aufweist.

3. Mikromechanische Struktur nach Anspruch 1 oder 2,
**dadurch gekennzeichnet**,
daß die Membran mindestens ein Loch aufweist, welches durch einen Verschlußdeckel (9) verschlossen ist.

4. Mikromechanische Struktur nach Anspruch 3,
**dadurch gekennzeichnet**,
daß der Verschlußdeckel aufseitig mit einem Ätzstopp (5) bedeckt ist, wobei ggf. zwischen Atzstopp und Verschlußdeckel eine parallel zur Membranfläche verlaufende durchgehende oder unterbrochene Verschlußschicht (4) vorhanden ist und die Summe der Dicke der Ätzstoppschicht und der ggf. vorhandenen Verschlußschicht geringer ist, als die Dicke der Abschlußstruktur (2).

5. Mikromechanische Struktur nach Anspruch 4,
**dadurch gekennzeichnet**,
daß die Öffnung (8) im Bereich benachbart von den Verschlußdeckeln bis zur Membranschicht (3) hinabreicht.

6. Mikromechanische Struktur nach mindestens einem der Ansprüche 1 bis 5,
**dadurch gekennzeichnet**,
daß die Fläche des Ätzstopps (5) weniger als 50% der freigelegten Membranfläche (11) beträgt.

7. Mikromechanische Struktur nach einem der Ansprüche 1 bis 6,
**dadurch gekennzeichnet**,
daß die Membran einstoffig ausgebildet ist.

8. Mikromechanische Struktur nach einem der Ansprüche 1 bis 7,
**dadurch gekennzeichnet**,
daß sich auf dem Chip der mikromechanischen Struktur eine Halbleiterschaltung mit einer Auswerte- und/oder Ansteuerelektronik für die mikromechanische Struktur befindet.

9. Verfahren zur Herstellung einer mikromechanischen Struktur umfassend die Schritte
a)Herstellung einer mikromechanischen Struktur umfassend ein Substrat (1), mindestens eine oberhalb des Substrats angeordnete Membran (3), welche ggf. Löcher zur Ätzung einer Öffnung (6) aufweist, einen zwischen Membran und Substrat angeordneten Hohlraum (6), mindestens eine als umlaufende Auflagefläche für die Membran dienende Opferschicht (7),
b)Aufbringen einer Abschlußstruktur (2) auf der Oberseite, so daß die Abschlußstruktur den Membranbereich und den außerhalb der Membran liegenden Bereich gemeinsam überdeckt,
c)Ätzung einer Öffnung (8) auf der Oberseite der Struktur, wobei die Öffnung einen Durchmesser (d_{A}) hat, welcher über den gesamten Umfang der Öffnung größer ist, als der Durchmesser (d_{H}) des Hohlraums (6) und
d)Verwendung eines Ätzverfahrens zur Ätzung der Öffnung (8), welches selektiv gegenüber der Membran und einem ggf. auf der Membran aufgebrachten Ätzstop (5) ist.

10. Verfahren nach Anspruch 9,
**dadurch gekennzeichnet**,
daß vor Schritt b) eine Freiätzung des Hohlraums (6) durch Einbringen eines Ätzmittels durch Löcher in der Membran erfolgt und im Anschluß daran die Löcher mit einem Verschlußdeckel (9) wieder verschlossen werden.

11. Verfahren nach Anspruch 10,
**dadurch gekennzeichnet**,
daß nach Verschließen der Löcher auf die Membran eine Verschlußschicht (4) aufgebracht wird.

12. Verfahren nach Anspruch 10 oder 11,
**dadurch gekennzeichnet**,
daß nach Verschließen der Löcher auf die Membran oder auf eine ggf. vorhandene Verschlußschicht ein Ätzstopp (5) aufgebracht wird, wobei der Ätzstopp nur im Bereich der Verschlußdeckel aufgebracht wird.

13. Verwendung der erfindungsgemäßen mikromechanischen Struktur nach Anspruch 1 für Sensoren.
